# EUROPEAN PATENT APPLICATION

(11) **EP 2 843 702 A1**
(43) Date of publication of application: **04.03.2015**
(21) Application number: 14158526.5
(22) Date of filing: 10.03.2014
(51) Int. Cl.: H01L 25/075, H01L 33/50, H01L 33/62

(54) **Semiconductor light emitting device**

(30) Priority: 30.08.2013 JP 2013180045
(71) Applicant: Kabushiki Kaisha Toshiba, Tokyo 105-8001 (JP)
(72) Inventor: Sugizaki, Yoshiaki, Tokyo 105-8001 (JP); Kojima, Akihiro, Tokyo 105-8001 (JP)
(74) Representative: Hoffmann Eitle

(57) **Abstract**

A semiconductor light emitting device (1) according to an embodiment includes a first semiconductor layer (21), a second semiconductor layer (22), a continuous insulating layer (13), a first fluorescer layer (14) and a second fluorescer layer (15). The first semiconductor layer (21) includes a first conductivity-type clad layer (21p), an active layer (21a), and a second conductivity-type clad layer (21n) stacked in the first semiconductor layer (21). The second semiconductor layer (22) includes a first conductivity-type clad layer (22p), an active layer (22a), and a second conductivity-type clad layer (22n) stacked in the second semiconductor layer (22). The continuous insulating layer (13) covers a side surface of the first semiconductor layer (21), a lower surface of the first semiconductor layer (21), a side surface of the second semiconductor layer (22), and a lower surface of the second semiconductor layer (22). The first fluorescer layer (14) covers an upper surface of the first semiconductor layer (21). The second fluorescer layer (15) covers an upper surface of the second semiconductor layer (22).

## Description

### FIELD

Embodiments described herein relate generally to a semiconductor light emitting device.

### BACKGROUND

Conventionally, a method for manufacturing a semiconductor light emitting device has been proposed in which a semiconductor layer is grown by crystal growth on a wafer; electrodes are formed on the semiconductor layer; sealing with a resin body is performed; and subsequently, the wafer is removed. According to such a method, fine structural bodies that are formed on the wafer can be packaged as-is; and fine semiconductor light emitting devices can be efficiently manufactured.

### BRIEF DESCRIPTION OF THE DRAWINGS

FIG. 1A is a plan view showing a semiconductor light emitting device according to a first embodiment; and FIG. 1B is a cross-sectional view along line A-A' shown in FIG. 1A;
FIG. 2A shows a disposition of semiconductor layers of the semiconductor light emitting device according to the first embodiment; and FIG. 2B is a figure showing a connectional relationship between the semiconductor layers and interconnect layers;
FIGS. 3A and 3B to FIGS. 5A and 5B show a method for manufacturing the semiconductor light emitting device according to the first embodiment;
FIG. 6 is a drawing in which FIG. 5A is superimposed onto FIG. 2B;
FIGS. 7A and 7B to FIGS. 10A and 10B show the method for manufacturing the semiconductor light emitting device according to the first embodiment;
FIGS. 11A and 11B are schematic cross-sectional views showing operations of the semiconductor light emitting device according to the first embodiment;
FIG. 12 is an xy chromaticity diagram showing colors of a light emitted by the semiconductor light emitting device according to the first embodiment;
FIGS. 13A and 13B are schematic cross-sectional views showing operations of a semiconductor light emitting device according to a second embodiment;
FIG. 14 is an xy chromaticity diagram showing colors of a light emitted by the semiconductor light emitting device according to the second embodiment;
FIG. 15 is a schematic cross-sectional view showing an operation of a semiconductor light emitting device according to a third embodiment;
FIG. 16 is a schematic cross-sectional view showing an operation of a semiconductor light emitting device according to a forth embodiment;
FIG. 17 is a plan view showing a disposition of pillars of the semiconductor light emitting device according to a fifth embodiment;
FIG. 18 is a plan view showing a disposition of pillars of a semiconductor light emitting device according to a sixth embodiment;
FIG. 19 is a figure showing a connectional relationship between semiconductor layers and interconnect layers of the semiconductor light emitting device according to the sixth embodiment;
FIG. 20 is a plan view showing a disposition of pillars of a semiconductor light emitting device according to a seventh embodiment;
FIG. 21 is a plan view showing a disposition of pillars of a semiconductor light emitting device according to an eighth embodiment; and
FIG. 22 is a figure showing a connectional relationship between semiconductor layers and interconnect layers of the semiconductor light emitting device according to the eighth embodiment.

### DETAILED DESCRIPTION

A semiconductor light emitting device according to an embodiment includes a first semiconductor layer, a second semiconductor layer, a continuous insulating layer, a first fluorescer layer and a second fluorescer layer. The first semiconductor layer includes a first conductivity-type clad layer, an active layer, and a second conductivity-type clad layer stacked in the first semiconductor layer. The second semiconductor layer includes a first conductivity-type clad layer, an active layer, and a second conductivity-type clad layer stacked in the second semiconductor layer. The continuous insulating layer covers a side surface of the first semiconductor layer, a lower surface of the first semiconductor layer, a side surface of the second semiconductor layer, and a lower surface of the second semiconductor layer. The first fluorescer layer covers an upper surface of the first semiconductor layer. The second fluorescer layer covers an upper surface of the second semiconductor layer.

Embodiments of the invention will now be described with reference to the drawings.

### (First embodiment)

First, a first embodiment will be described.

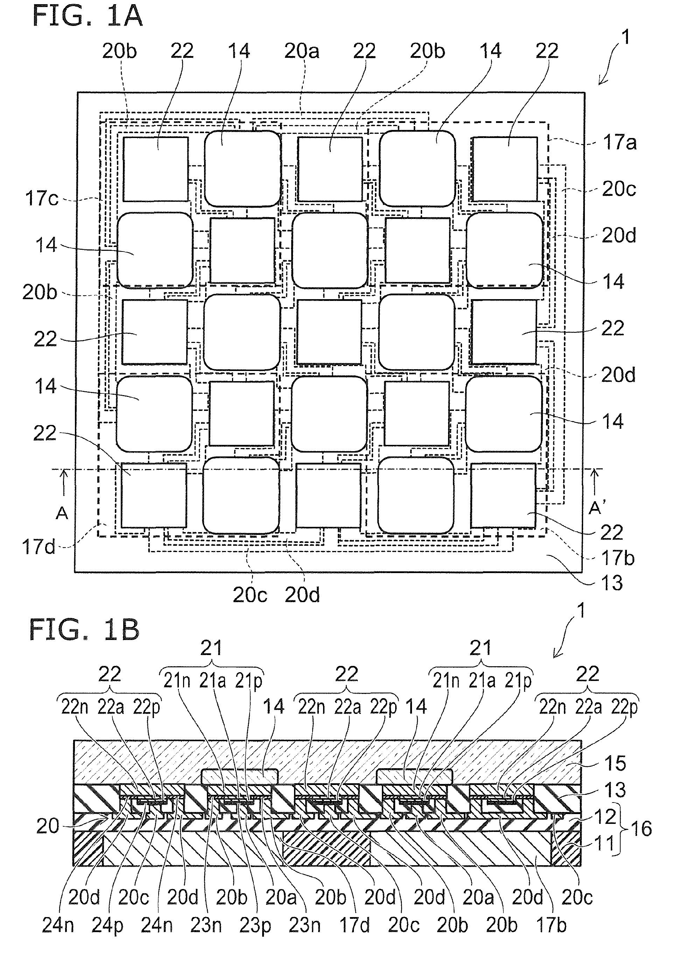

FIG. 1A is a plan view showing a semiconductor light emitting device according to the embodiment; and FIG. 1B is a cross-sectional view along line A-A' shown in FIG. 1A.

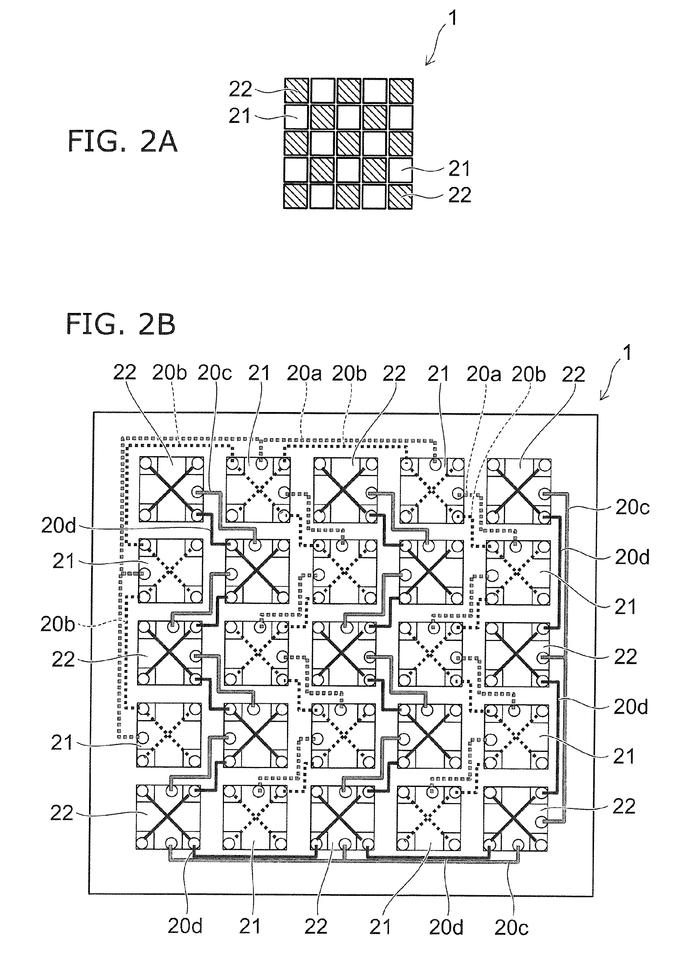

FIG. 2A shows the disposition of semiconductor layers of the semiconductor light emitting device according to the embodiment; and FIG. 2B is a figure showing the connectional relationship between the semiconductor layers and the interconnect layers.

As shown in FIGS. 1A and 1B, an insulating layer 11, an insulating layer 12, an insulating layer 13, and a fluorescer layer 15 are stacked in this order in the semiconductor light emitting device 1 according to the embodiment. The fluorescer layer 15 is not shown for convenience of illustration in FIG. 1A. For convenience of description hereinbelow, the insulating layer 11 side is called "down" and the fluorescer layer 15 side is called "up;" but such notation is independent of the direction of gravity.

The insulating layers 11 to 13 are formed of an insulating material. The insulating layer 11 is formed of, for example, an opaque resin material. The insulating layer 12 and the insulating layer 13 are formed of, for example, silicon oxide, silicon nitride, alumina, aluminum nitride, silicone polymer, polyimide, PBO, BCB or Parylene. Pillars 17a to 17d that are made of a conductive material such as, for example, copper (Cu), etc., are provided inside the insulating layer 11. The pillars 17a to 17d have, for example, quadrilateral columnar configurations. The pillars 17a to 17d pierce the insulating layer 11 in the vertical direction such that the lower surfaces of the pillars 17a to 17d are exposed at the lower surface of the insulating layer 11. In the specification, "covering" refers to both the state in which the covering object contacts the covered object and the state in which the covering object does not contact the covered object.

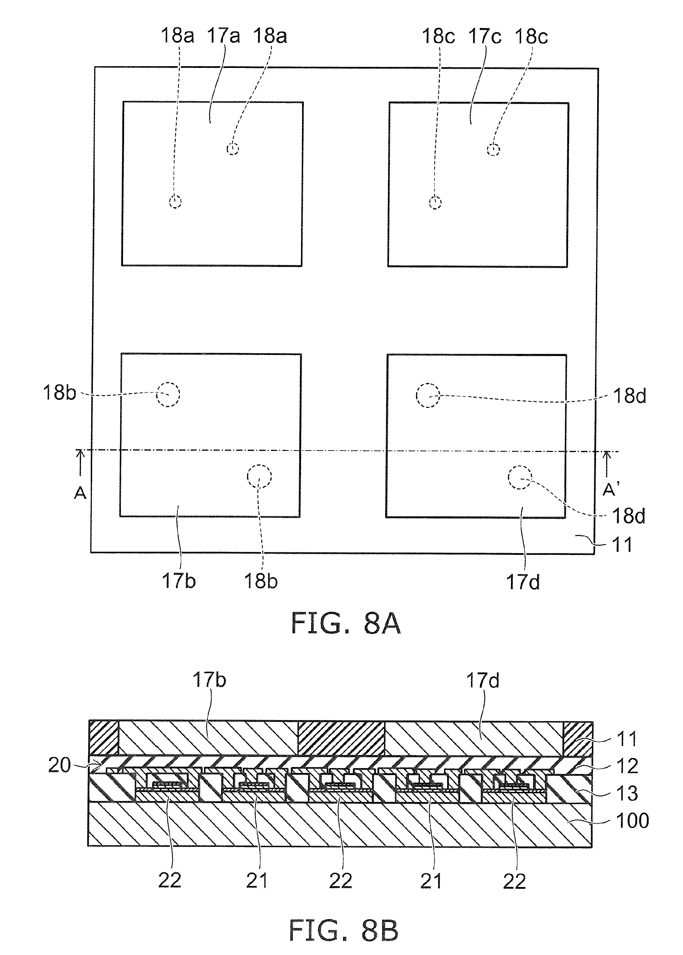

For example, two of each for vias 18a to 18d (referring to FIG. 8A) are provided inside the insulating layer 12. The vias 18a to 18d are disposed in regions directly above the pillars 17a to 17d, respectively, to pierce the insulating layer 12 in the vertical direction to be connected to the pillars 17a to 17d, respectively. In the specification, "connecting" refers to being electrically connected. The insulating layer 12 covers the upper surfaces of the pillars 17a to 17d. An insulating film 16 includes the insulating layer 11 and the insulating layer 12. Accordingly, the insulating film 16 covers the side surfaces and upper surfaces of the pillars 17a to 17d.

An interconnect layer 20 that is made of a conductive material such as, for example, copper, aluminum, nickel, gold, conductive paste, copper nano-paste, silver nano-paste or etc., is provided inside the upper portion of the insulating layer 12 and inside the lower portion of the insulating layer 13. The lower portion of the interconnect layer 20 is positioned inside the upper portion of the insulating layer 12 and is formed in an interconnect configuration. The upper portion of the interconnect layer 20 is positioned inside the lower portion of the insulating layer 13 and is formed in a via configuration. The interconnect layer 20 is divided into multiple portions; and each portion is classified into one selected from interconnect layers 20a to 20d. The interconnect layers 20a to 20d are respectively connected to the vias 18a to 18d.

Multiple semiconductor layers 21 and multiple semiconductor layers 22 are provided to be separated from each other inside the upper portion of the insulating layer 13. The semiconductor layers 21 and 22 have, for example, square plate configurations that are patterned into high mesas. As described below, the semiconductor layers 21 and 22 are formed by patterning one semiconductor layer to subdivide the one semiconductor layer into multiple portions; and the semiconductor layers 21 and 22 are LED (Light Emitting Diode) layers including, for example, indium gallium nitride (InGaN) that emit, for example, blue light. The lower surfaces and side surfaces of the semiconductor layers 21 and 22 are covered with the insulating layer 13; and the upper surfaces of the semiconductor layers 21 and 22 are exposed at the upper surface of the insulating layer 13. The insulating layer 13 is a single continuous insulating layer covering the side surfaces and lower surfaces of all of the semiconductor layers 21 and the side surfaces and lower surfaces of all of the semiconductor layers 22 continuously.

As shown in FIG. 1B, a p-type clad layer 21p, an active layer 21a, and an n-type clad layer 21n are stacked in order from below in the semiconductor layer 21. At the four corners of the semiconductor layer 21, the p-type clad layer 21p and the active layer 21a are removed; and the n-type clad layer 21n is exposed at the lower surface of the semiconductor layer 21. In other words, the p-type clad layer 21p is patterned into a high mesa in a cross-shaped configuration as viewed from below. A p-side electrode 23p that has a cross-shaped configuration is provided on the lower surface of the p-type clad layer 21p to be connected to the p-type clad layer 21p. N-side electrodes 23n that are rectangles are provided respectively on the exposed surfaces of the lower surface of the n-type clad layer 21n to be connected to the n-type clad layer 21n.

Similarly, a p-type clad layer 22p, an active layer 22a, and an n-type clad layer 22n are stacked in order from below in the semiconductor layer 22. At the four corners of the semiconductor layer 22, the p-type clad layer 22p and the active layer 22a are removed; and the n-type clad layer 22n is exposed at the lower surface of the semiconductor layer 22. A p-side electrode 24p that has a cross-shaped configuration is provided on the lower surface of the p-type clad layer 22p to be connected to the p-type clad layer 22p; and n-side electrodes 24n that are rectangles are provided respectively on the exposed surfaces of the lower surface of the n-type clad layer 22n to be connected to the n-type clad layer 22n.

As shown in FIG. 2A, when viewed from above, the semiconductor layers 21 are arranged in a staggered configuration; the semiconductor layers 22 are arranged in a staggered configuration; and the semiconductor layers 21 and the semiconductor layers 22 as an entirety are arranged in a matrix configuration. In the embodiment, the semiconductor layers 21 and 22 are arranged in a matrix configuration of, for example, five rows by five columns.

In FIG. 2B, the interconnect layers 20a to 20d are schematically illustrated by straight lines. As shown in FIG. 1A, FIG. 1B, and FIG. 2B, the p-type clad layers 21p of the semiconductor layer 21 are connected to each other by the interconnect layer 20a and are connected to the pillar 17a by means of the via 18a. The n-type clad layers 21n of the semiconductor layer 21 are connected to each other by the interconnect layer 20b and are connected to the pillar 17b by means of the via 18b. The p-type clad layers 22p of the semiconductor layer 22 are connected to each other by the interconnect layer 20c and are connected to the pillar 17c by means of the via 18c. The n-type clad layers 22n of the semiconductor layer 22 are connected to each other by the interconnect layer 20d and are connected to the pillar 17d by means of the via 18d.

Thereby, a circuit block that is made of (pillar 17a - via 18a - interconnect layer 20a - p-side electrode 23p - p-type clad layer 21p - active layer 21a - n-type clad layer 21n - n-side electrode 23n - interconnect layer 20b - via 18b - pillar 17b) is formed between the pillar 17a and the pillar 17b to connect the multiple semiconductor layers 21 to each other in parallel. Also, a circuit block that is made of (pillar 17c - via 18c - interconnect layer 20c - p-side electrode 24p - p-type clad layer 22p - active layer 22a - n-type clad layer 22n - n-side electrode 24n - interconnect layer 20d - via 18d - pillar 17d) is formed between the pillar 17c and the pillar 17d to connect the multiple semiconductor layers 22 to each other in parallel.

As shown in FIGS. 1A and 1B, fluorescer layers 14 are provided on the upper surfaces of the semiconductor layers 21 to cover the upper surfaces of the semiconductor layers 21. In other words, the same number of fluorescer layers 14 as semiconductor layers 21 are provided; and the fluorescer layer 14 is disposed at each semiconductor layer 21. When viewed from above, the configuration of each of the fluorescer layers 14 is, for example, a square having rounded corners. A prescribed fluorescer (not shown) is dispersed in the transparent resin layer of the fluorescer layer 14 to emit red light when the blue light emitted from the semiconductor layer 21 is incident.

The fluorescer layer 15 is provided on the entire surface of the insulating layer 13 to cover all of the fluorescer layers 14. Thereby, one fluorescer layer 15 covers the upper surfaces of the semiconductor layers 21 and the upper surfaces of the semiconductor layers 22. A prescribed fluorescer (not shown) is dispersed in the transparent resin layer of the fluorescer layer 15 to emit yellow light when the blue light emitted from the semiconductor layers 21 and 22 is incident.

The configuration of the semiconductor light emitting device 1 is, for example, a rectangular parallelepiped, e.g., a square rectangular parallelepiped, as viewed from above. The outer surface of the semiconductor light emitting device 1 includes the fluorescer layer 15, the insulating layer 13, the insulating film 16, and the pillars 17a to 17d. Thereby, all of the semiconductor layers 21 and semiconductor layers 22 are sealed inside a single package.

A method for manufacturing the semiconductor light emitting device according to the embodiment will now be described.

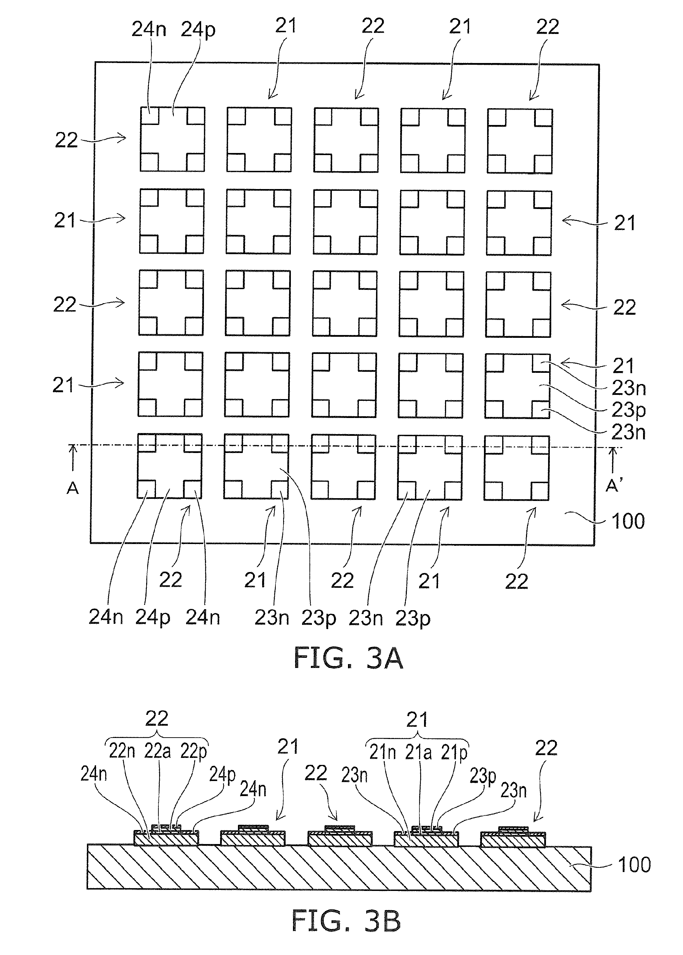

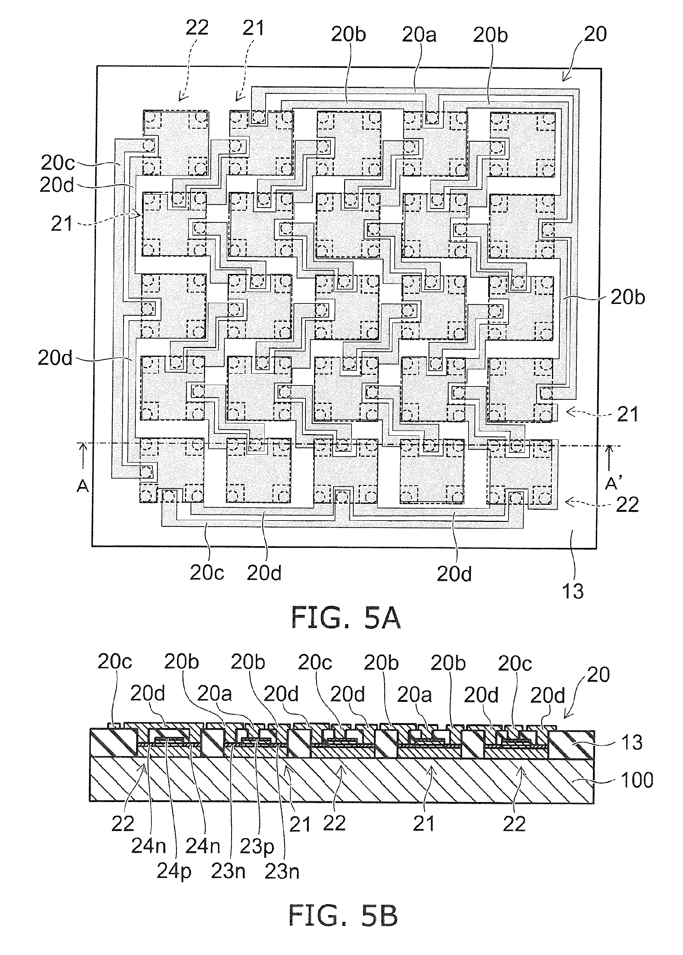

FIGS. 3A and 3B to FIGS. 5A and 5B show the method for manufacturing the semiconductor light emitting device according to the embodiment.

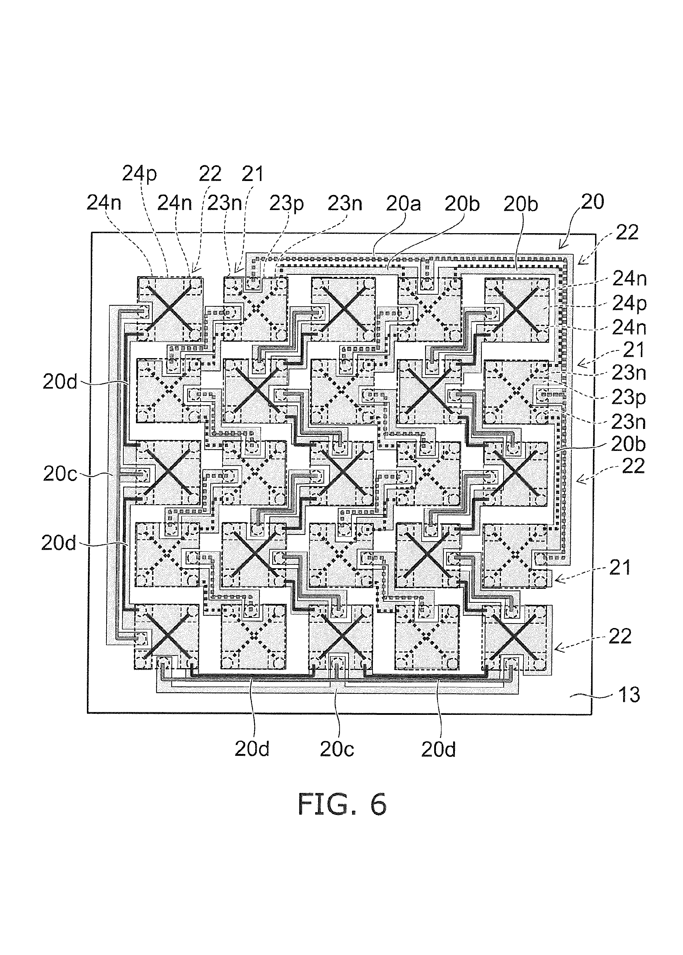

FIG. 6 is a drawing in which FIG. 5A is superimposed onto FIG. 2B. However, the directions of left and right are reversed from those of FIG. 2B.

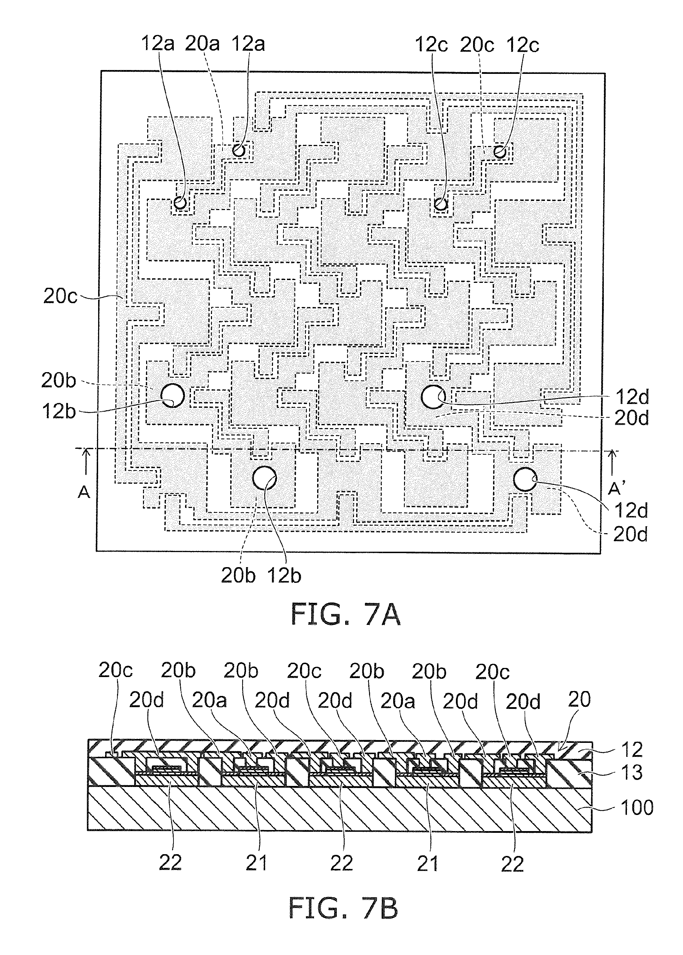

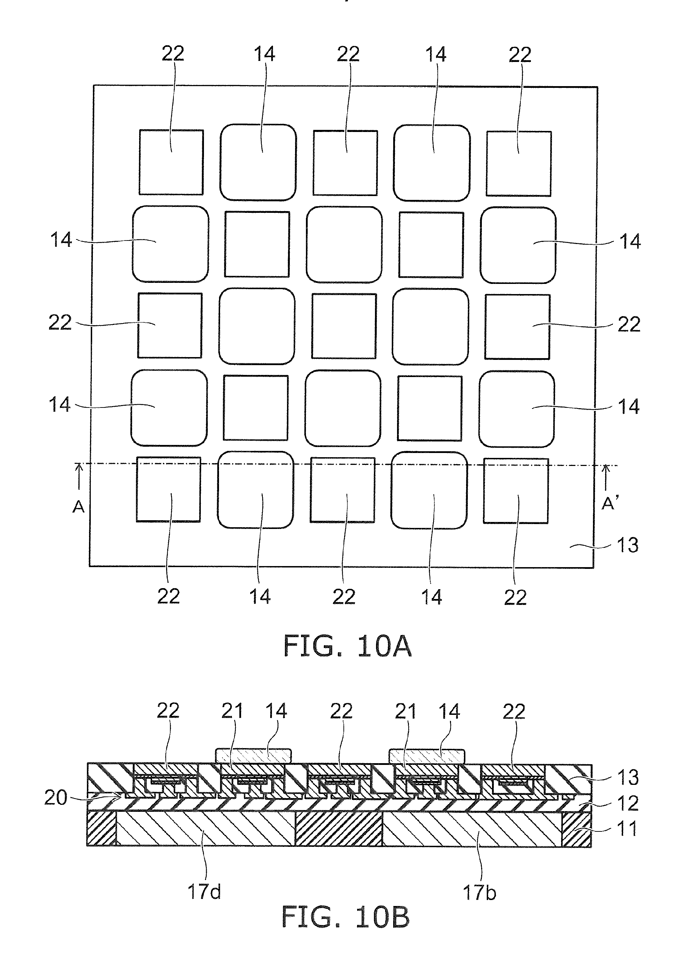

FIGS. 7A and 7B to FIGS. 10A and 10B show the method for manufacturing the semiconductor light emitting device according to the embodiment.

In the description hereinbelow, the notation of "up" and "down" in the processes shown in FIGS. 3A and 3B to FIGS. 8A and 8B is reversed from the description of the configuration shown in FIGS. 1A and 1B and FIGS. 2A and 2B described above.

First, as shown in FIGS. 3A and 3B, a crystal growth substrate 100 is prepared. The crystal growth substrate 100 is formed of, for example, monocrystalline sapphire (Al₂O₃), silicon carbide (SiC), silicon (Si), etc. Although the description hereinbelow focuses on structures that are used to form one semiconductor light emitting device 1, a wafer may be used as the crystal growth substrate 100 such that structures that are used to form multiple semiconductor light emitting devices 1 are made simultaneously on one wafer, and dicing and singulation are performed subsequently.

A semiconductor layer in which an n-type clad layer, an active layer, and a p-type clad layer are stacked in this order is formed on the crystal growth substrate 100 by performing epitaxial growth of, for example, gallium nitride (GaN). Then, the semiconductor layer is patterned to be subdivided into multiple square portions arranged in a matrix configuration; and the p-type clad layer and the active layer are removed from the corners of each of the portions to expose the n-type clad layer.

Thus, multiple semiconductor layers are formed on the crystal growth substrate 100, are arranged in a matrix configuration, are separated from each other, are squares as viewed from above, include the n-type clad layer, the active layer, and the p-type clad layer stacked in this order, and have corners that are patterned into high mesas. Among the semiconductor layers, every other semiconductor layer that is disposed in a staggered configuration is called the semiconductor layer 21; and the remaining semiconductor layers are called the semiconductor layer 22. The configuration of the semiconductor layer 21 and the configuration of the semiconductor layer 22 are the same.

Then, the p-side electrode 23p is formed on the p-type clad layer 21p of the semiconductor layer 21; the n-side electrodes 23n are formed on the exposed surfaces of the n-type clad layer 21n; the p-side electrode 24p is formed on the p-type clad layer 22p of the semiconductor layer 22; and the n-side electrodes 24n are formed on the exposed surfaces of the n-type clad layer 22n.

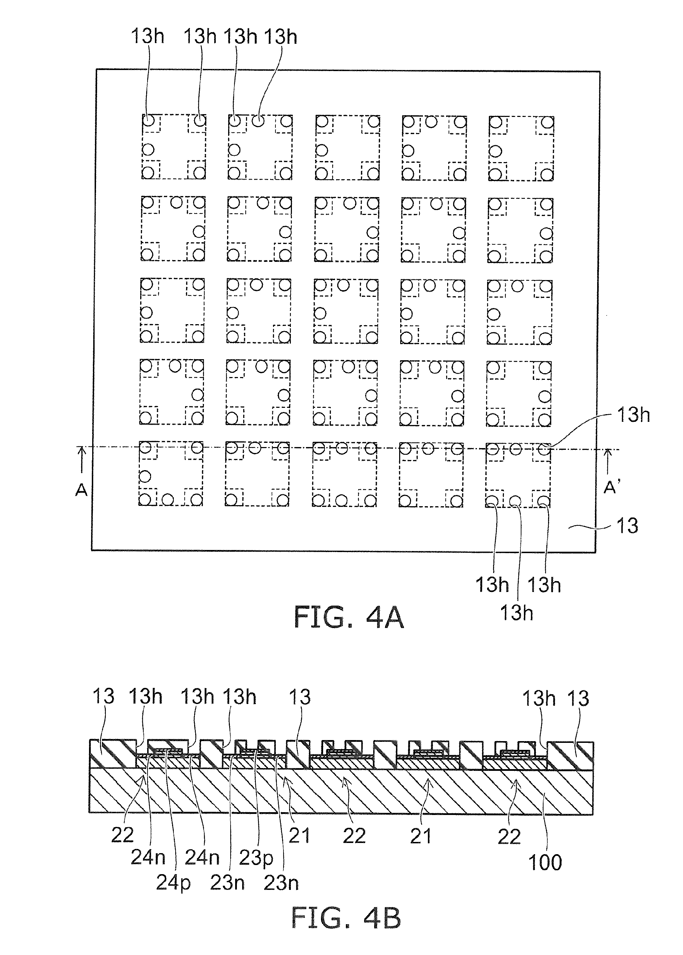

Continuing as shown in FIGS. 4A and 4B, the insulating layer 13 is formed on the crystal growth substrate 100 to cover the semiconductor layers 21 and 22; and via holes 13h are made respectively in portions of the regions directly above the p-side electrodes 23p, portions of the regions directly above the n-side electrodes 23n, portions of the regions directly above the p-side electrodes 24p, and portions of the regions directly above the n-side electrodes 24n.

Then, as shown in FIGS. 5A and 5B, a seed layer (not shown) is formed on the insulating layer 13. Continuing, a resist film is formed; and a resist pattern (not shown) is formed by patterning the resist film. Then, copper is electroplated; and subsequently, the resist pattern is removed. Thereby, the interconnect layer 20 is formed. A portion of the interconnect layer 20 is filled into the via holes 13h in via configurations to be connected to the p-side electrodes 23p, the n-side electrodes 23n, the p-side electrodes 24p, and the n-side electrodes 24n.

As shown in FIG. 6, the portions of the interconnect layer 20 are separated from each other and are classified into the interconnect layer 20a that connects the p-side electrodes 23p to each other, the interconnect layer 20b that connects the n-side electrodes 23n to each other, the interconnect layer 20c that connects the p-side electrodes 24p to each other, and the interconnect layer 20d that connects the n-side electrodes 24n to each other.

Then, as shown in FIGS. 7A and 7B, the insulating layer 12 is formed above the insulating layer 13 and the interconnect layer 20 to cover the insulating layer 13 and the interconnect layer 20. Then, via holes 12a to 12d are made in the insulating layer 12, for example, two via holes apiece, for a portion of the region directly above the interconnect layer 20a, a portion of the region directly above the interconnect layer 20b, a portion of the region directly above the interconnect layer 20c, and a portion of the region directly above the interconnect layer 20d.

Continuing as shown in FIGS. 8A and 8B, a seed layer (not shown) is formed on the insulating layer 12. Then, a resist film is formed; and a resist pattern (not shown) is formed by patterning the resist film. Continuing, copper is electroplated; and subsequently, the resist pattern is removed. Thereby, the vias 18a to 18d and the pillars 17a to 17d are made. In other words, the portions of the copper film that are deposited by the electroplating to be filled into the via holes 12a to 12d are used as the vias 18a to 18d, respectively. Further, the pillars 17a to 17d that are quadrilateral columns are formed on the insulating layer 12 to be connected respectively to the vias 18a to 18d. Then, the insulating layer 11 is formed to fill between the pillars 17a to 17d by coating an insulating resin material.

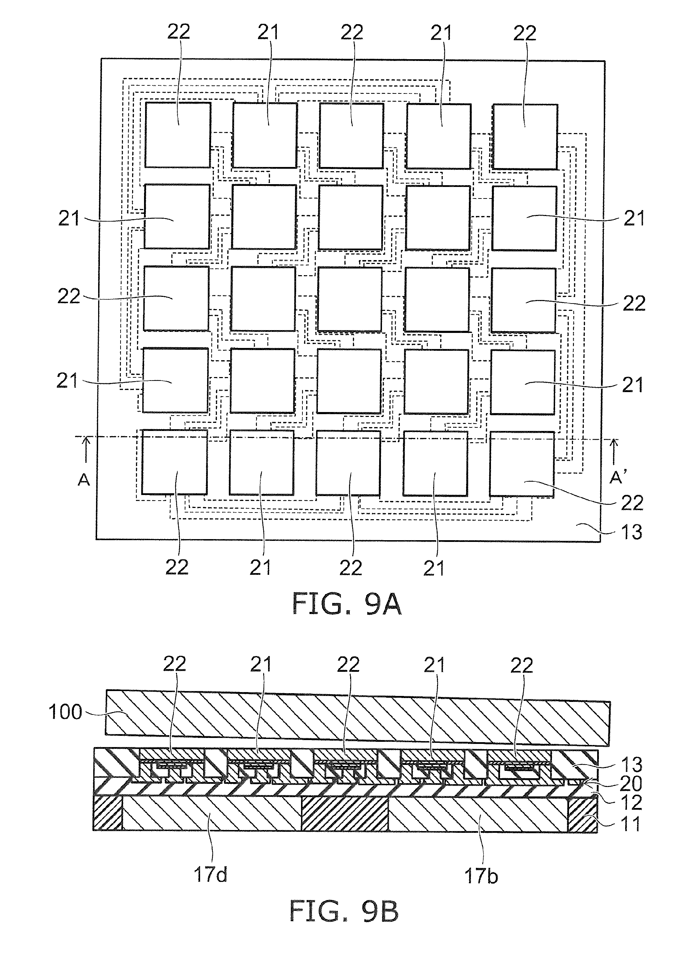

Then, as shown in FIGS. 9A and 9B, the directions of up and down for the structural bodies is reversed partway through the manufacturing. Hereinbelow, the notation of up and down is reversed from the description of FIGS. 3A and 3B to FIGS. 8A and 8B to match the description of FIGS. 1A and 1B and FIGS. 2A and 2B.

Continuing, the crystal growth substrate 100 is removed by a method such as laser lift-off, mechanical polishing, etching, etc. Thereby, the upper surfaces of the semiconductor layers 21 and 22 are exposed at the upper surface of the insulating layer 13, i.e., the surface that was in contact with the crystal growth substrate 100. The crystal growth substrate 100 is not shown in FIG. 9A.

Then, as shown in FIGS. 10A and 10B, the multiple fluorescer layers 14 are formed on the insulating layer 13 in regions including the regions directly above the semiconductor layers 21 to cover the upper surfaces of the semiconductor layers 21. The multiple fluorescer layers 14 are arranged in a staggered configuration.

Continuing as shown in FIGS. 1A and 1B, one fluorescer layer 15 is formed on the entire surface of the insulating layer 13. The fluorescer layer 15 covers the semiconductor layers 21, the semiconductor layers 22, and the fluorescer layers 14. Subsequently, singulation is performed by dicing if necessary. Thereby, the semiconductor light emitting device 1 according to the embodiment is manufactured.

Operations and effects of the embodiment will now be described.

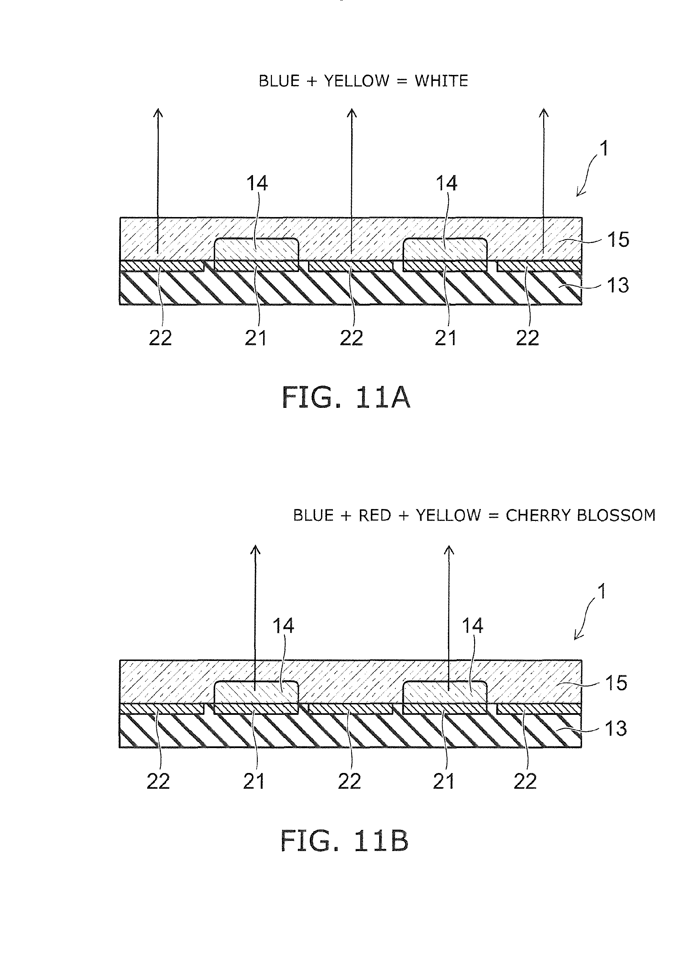

FIGS. 11A and 11B are schematic cross-sectional views showing operations of the semiconductor light emitting device according to the embodiment.

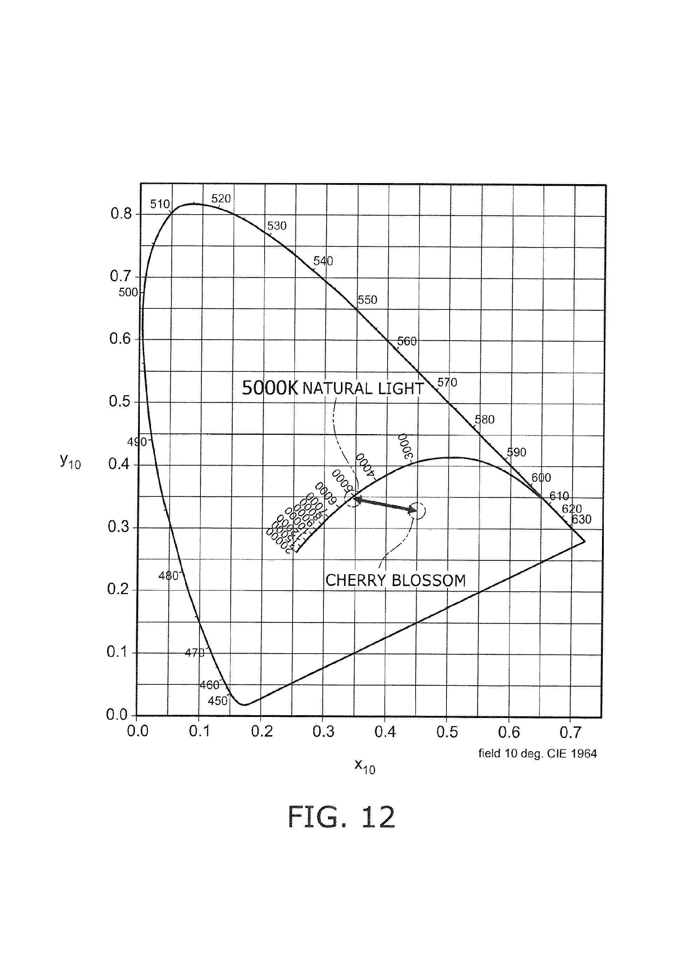

FIG. 12 is an xy chromaticity diagram showing colors of the light emitted by the semiconductor light emitting device according to the embodiment.

As shown in FIGS. 11A and 11B, the semiconductor layers 21 and 22 emit blue light. The fluorescer layers 14 emit red light when the blue light is incident; and the fluorescer layer 15 emits yellow light when the blue light is incident.

As shown in FIG. 11A, when only the semiconductor layers 22 are caused to emit light without the semiconductor layers 21 emitting light by applying a voltage only between the pillar 17c and the pillar 17d without applying a voltage between the pillar 17a (referring to FIG. 1A) and the pillar 17b, the light that is emitted from the semiconductor layers 22 substantially passes through only the fluorescer layer 15. Therefore, a portion of the blue light emitted from the semiconductor layers 22 is converted into yellow light by the fluorescer layer 15; and the remainder of the blue light passes through as-is without being absorbed by the fluorescer layer 15. As a result, the blue light and the yellow light are emitted from the semiconductor light emitting device 1; and the tint of the emitted light as an entirety is white, e.g., natural light having a color temperature of 5000 K.

On the other hand, as shown in FIG. 11B, when only the semiconductor layers 21 are caused to emit light without the semiconductor layers 22 emitting light by applying a voltage only between the pillar 17a and the pillar 17b without applying a voltage between the pillar 17c and the pillar 17d, the light that is emitted by the semiconductor layers 21 passes through the fluorescer layer 15 and the fluorescer layers 14. Thereby, red light is emitted from the semiconductor light emitting device 1 in addition to the blue light and the yellow light. As a result, the tint of the light that is emitted by the semiconductor light emitting device 1 as an entirety is a cherry blossom color.

Then, as shown in FIG. 12, the tint of the light that is emitted by the semiconductor light emitting device 1 can be adjusted between natural light and cherry blossom by controlling the voltage applied between the pillar 17a and the pillar 17b and the voltage applied between the pillar 17c and the pillar 17d. For example, it is also possible for the tint of the emitted light to be intermediate tints between natural light and cherry blossom. Thus, according to the semiconductor light emitting device according to the embodiment, the tint of the emitted light can be adjusted easily by merely controlling the potentials of four terminals, i.e., the pillars 17a to 17d.

The pillar 17b which is the negative terminal of the semiconductor layers 21 may be connected to the pillar 17d which is the negative terminal of the semiconductor layers 22. In such a case, the tint of the emitted light can be adjusted by controlling the potentials of three terminals. Also, the pillar 17b and the pillar 17d may have a common connection to the ground potential. In such a case, the tint of the emitted light can be adjusted by controlling the potentials of substantially two terminals. The pillar 17a which is the positive terminal of the semiconductor layers 21 may be connected to the pillar 17c which is the positive terminal of the semiconductor layers 22; the pillar 17a may be connected to the pillar 17d; or the pillar 17b may be connected to the pillar 17c.

According to the embodiment, multiple semiconductor layers can be formed simultaneously in a micro region because the multiple semiconductor layers 21 and 22 are formed by forming a semiconductor layer collectively on the crystal growth substrate 100 and by subdividing the semiconductor layer. The interconnect layers 20a to 20d, the vias 18a to 18d, and the pillars 17a to 17d can be formed in the same process. As a result, according to the embodiment, a small semiconductor light emitting device for which toning is possible can be manufactured by easy processes.

Further, according to the embodiment, color breakup, i.e., the angle dependence of the tint of the emitted light, can be suppressed by arranging the multiple semiconductor layers 21 and the multiple semiconductor layers 22 in staggered configurations.

### (Second embodiment)

A second embodiment will now be described.

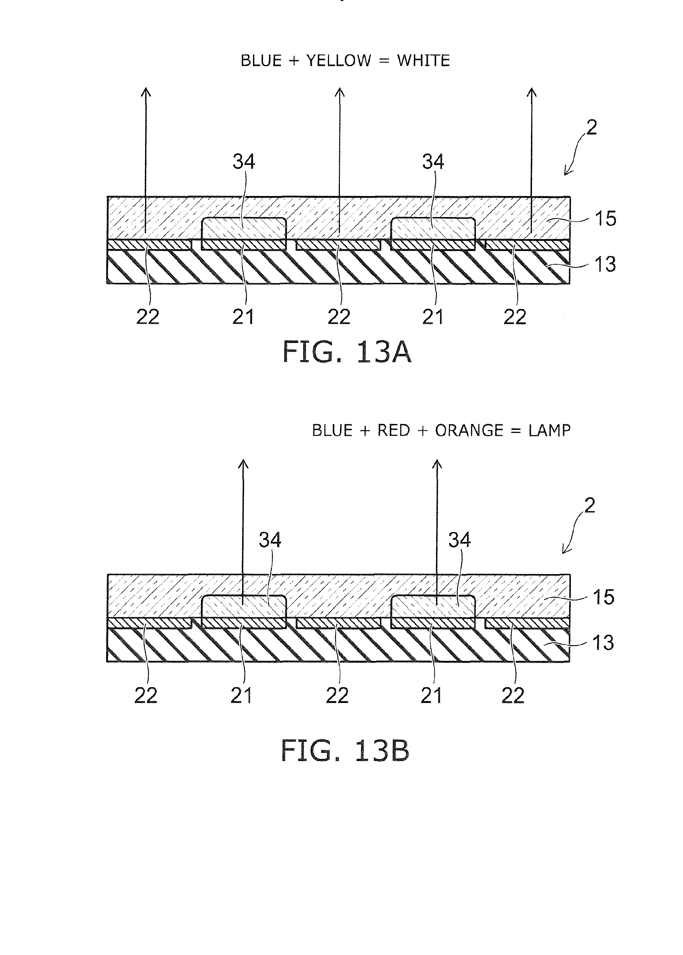

FIGS. 13A and 13B are schematic cross-sectional views showing operations of a semiconductor light emitting device according to the embodiment.

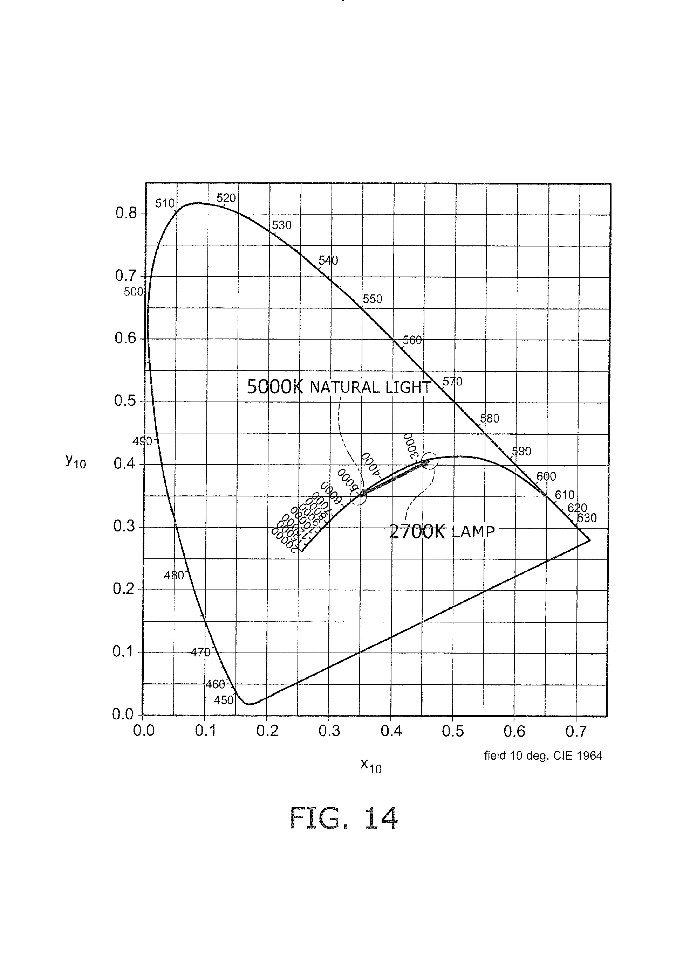

FIG. 14 is an xy chromaticity diagram showing colors of the light emitted by the semiconductor light emitting device according to the embodiment.

As shown in FIGS. 13A and 13B, the semiconductor light emitting device 2 according to the embodiment differs from the semiconductor light emitting device 1 (referring to FIGS. 11A and 11B) according to the first embodiment described above in that fluorescer layers 34 are provided instead of the fluorescer layers 14. The fluorescer layers 34 emit light that is reddish yellow, e.g., orange, when the blue light emitted from the semiconductor layers 21 is incident.

Thereby, similarly to the first embodiment described above, when only the semiconductor layers 22 are caused to emit light as shown in FIG. 13A, blue light and yellow light are emitted from the semiconductor light emitting device 2; and the tint of the emitted light as an entirety is, for example, natural light having a color temperature of 5000 K. On the other hand, when only the semiconductor layers 21 are caused to emit light as shown in FIG. 13B, blue light, orange light, and yellow light are emitted from the semiconductor light emitting device 2; and the tint of the emitted light as an entirety is, for example, lamp having a color temperature of 2700 K. Accordingly, as shown in FIG. 14, the tint of the light emitted from the semiconductor light emitting device 1 can be adjusted arbitrarily between natural light and lamp. Otherwise, the configuration, the manufacturing method, the operations, and the effects of the embodiment are similar to those of the first embodiment described above.

### (Third embodiment)

A third embodiment will now be described.

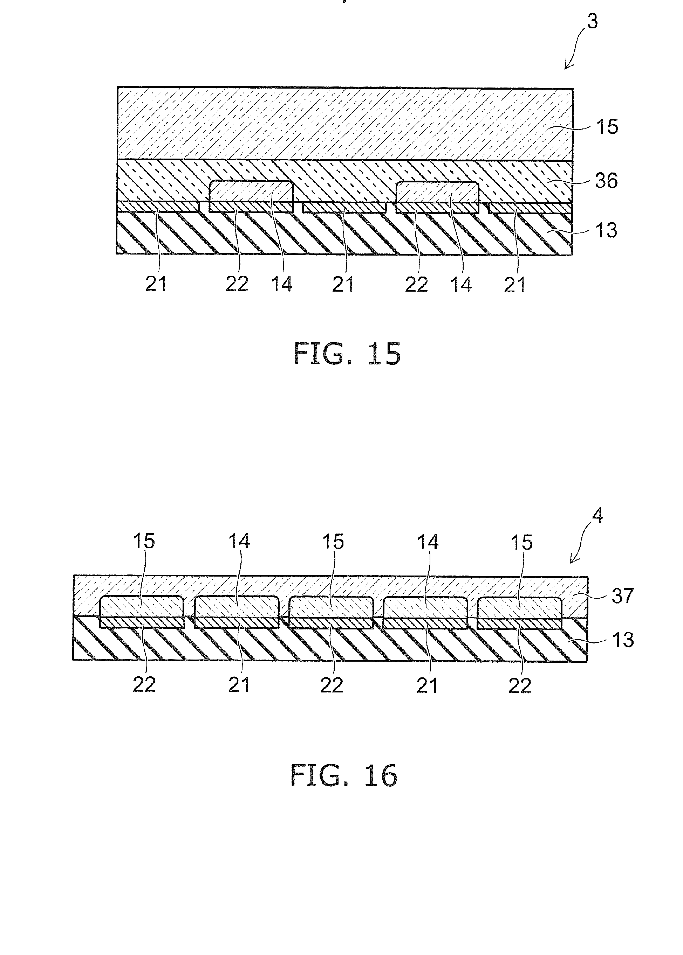

FIG. 15 is a schematic cross-sectional view showing an operation of the semiconductor light emitting device according to the embodiment.

As shown in FIG. 15, a transparent layer 36 that is made of a transparent resin material is provided between the fluorescer layer 15 and the fluorescer layers 14 in the semiconductor light emitting device 3 according to the embodiment. In the specification, "transparent" also includes being semi-transparent. Thereby, the fluorescer layers 14 can be thermally isolated from the fluorescer layer 15; and more stable operations are possible. Otherwise, the configuration, the manufacturing method, the operations, and the effects of the embodiment are similar to those of the first embodiment described above.

### (Fourth embodiment)

A fourth embodiment will now be described.

FIG. 16 is a schematic cross-sectional view showing an operation of the semiconductor light emitting device according to the embodiment.

As shown in FIG. 16, the semiconductor light emitting device 4 according to the embodiment differs from the semiconductor light emitting device 1 (referring to FIGS. 11A and 11B) according to the first embodiment described above in that the fluorescer layers 15 are disposed to cover only the upper surfaces of the semiconductor layers 22 and do not cover the fluorescer layers 14. The fluorescer layers 14 and the fluorescer layers 15 are covered with a transparent layer 37.

According to the embodiment, the light that is emitted by the semiconductor layers 21 passes through only the fluorescer layers 14 and does not pass through the fluorescer layers 15. Thereby, compared to the first embodiment described above, the tint of the emitted light can be adjusted in a wider range in the xy chromaticity diagram. Otherwise, the configuration, the manufacturing method, the operations, and the effects of the embodiment are similar to those of the first embodiment described above.

### (Fifth embodiment)

A fifth embodiment will now be described.

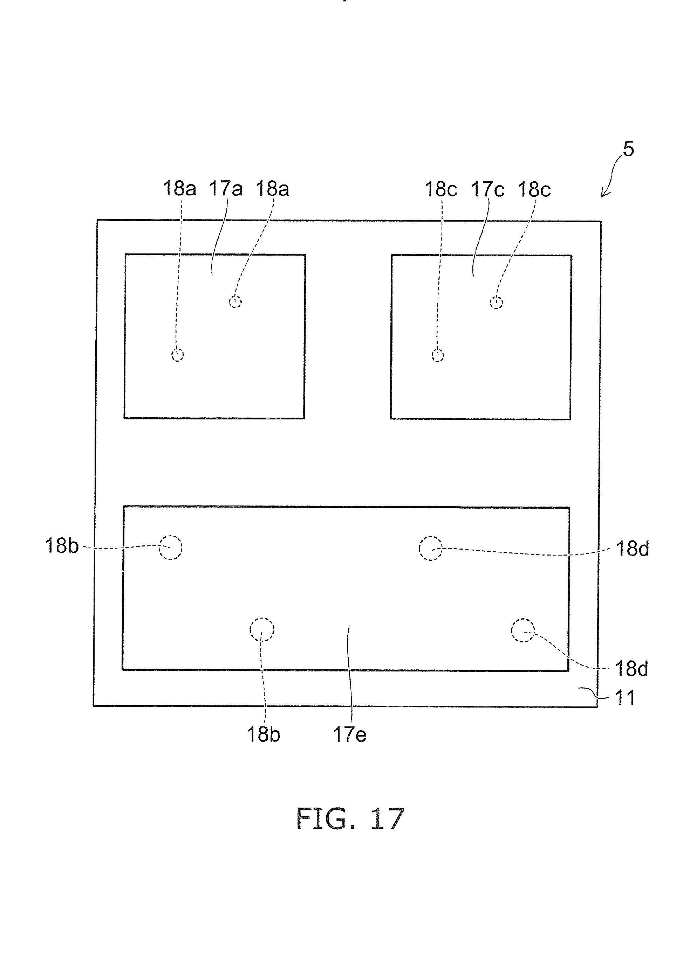

FIG. 17 is a plan view showing the disposition of the pillars of the semiconductor light emitting device according to the embodiment.

As shown in FIG. 17, the semiconductor light emitting device 5 according to the embodiment differs from the semiconductor light emitting device 1 (referring to FIGS. 8A and 8B) according to the first embodiment described above in that one common pillar 17e is provided instead of the pillar 17b which is the negative terminal of the semiconductor layers 21 and the pillar 17d which is the negative terminal of the semiconductor layers 22. The pillar 17e is connected to the interconnect layer 20b by means of the via 18b and is connected to the interconnect layer 20d by means of the via 18d. Thereby, the tint of the emitted light can be adjusted by controlling the potentials of three terminals. Otherwise, the configuration, the manufacturing method, the operations, and the effects of the embodiment are similar to those of the first embodiment described above.

### (Sixth embodiment)

A sixth embodiment will now be described.

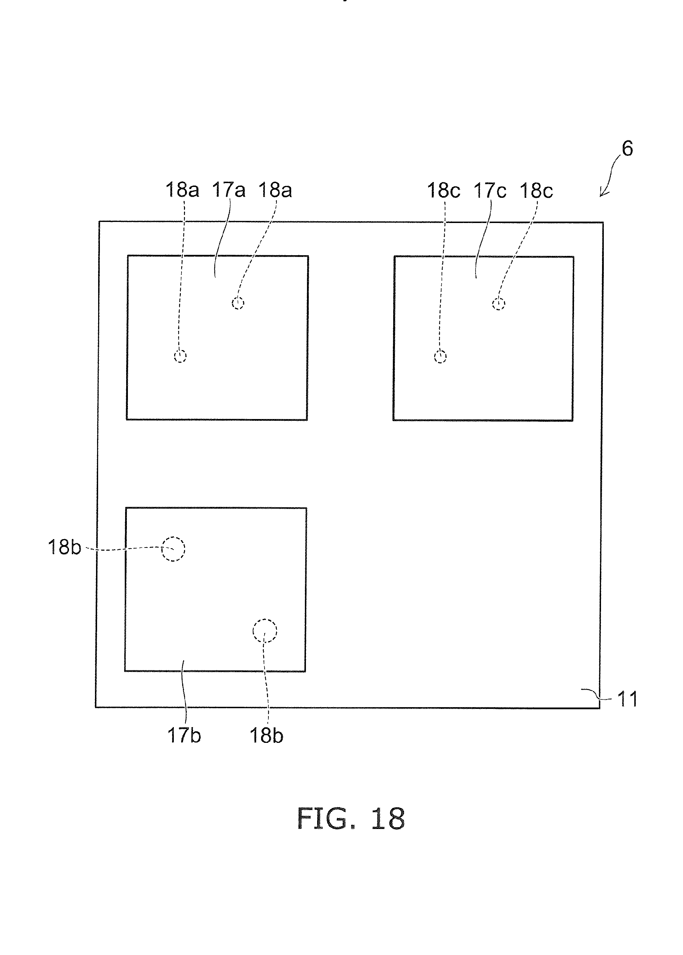

FIG. 18 is a plan view showing the disposition of the pillars of the semiconductor light emitting device according to the embodiment.

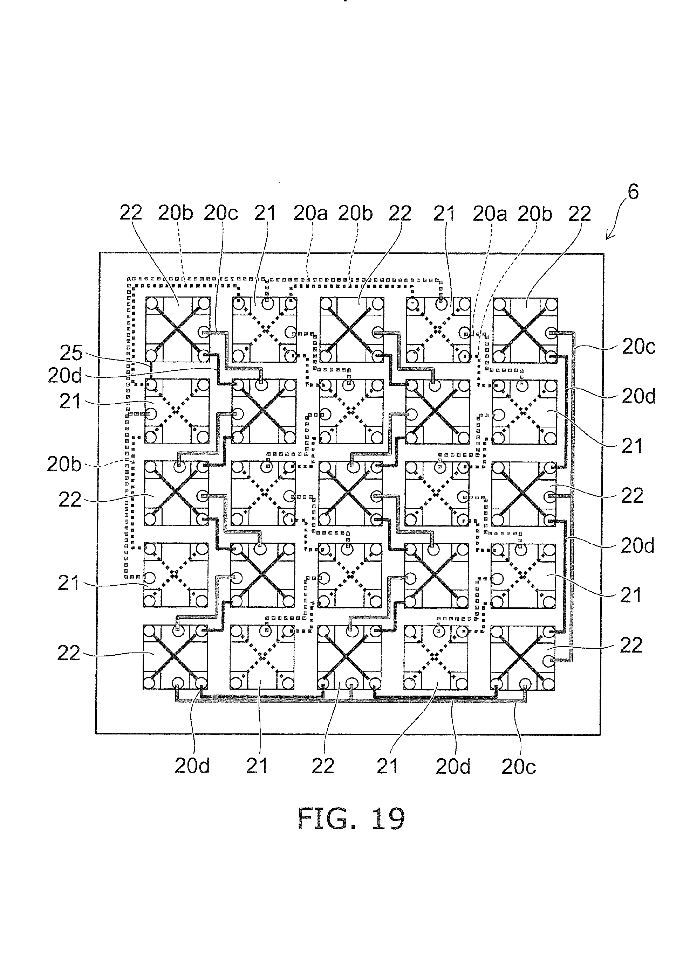

FIG. 19 is a figure showing the connectional relationship between the semiconductor layers and the interconnect layers of the semiconductor light emitting device according to the embodiment.

As shown in FIG. 18, the semiconductor light emitting device 6 according to the embodiment differs from the semiconductor light emitting device 1 (referring to FIG. 2B and FIG. 8A) according to the first embodiment described above in that the pillar 17d and the via 18d are not provided. Also, as shown in FIG. 19, the interconnect layer 20d is connected to the interconnect layer 20b via an interconnect 25. Accordingly, the pillar 17b is connected to both the interconnect layer 20b and the interconnect layer 20d and is connected to both the negative terminal of the semiconductor layers 21 and the negative terminal of the semiconductor layers 22. Thereby, according to the embodiment as well, similarly to the fifth embodiment, the tint of the emitted light can be adjusted by controlling the potentials of three terminals. Otherwise, the configuration, the manufacturing method, the operations, and the effects of the embodiment are similar to those of the first embodiment described above.

### (Seventh embodiment)

A seventh embodiment will now be described.

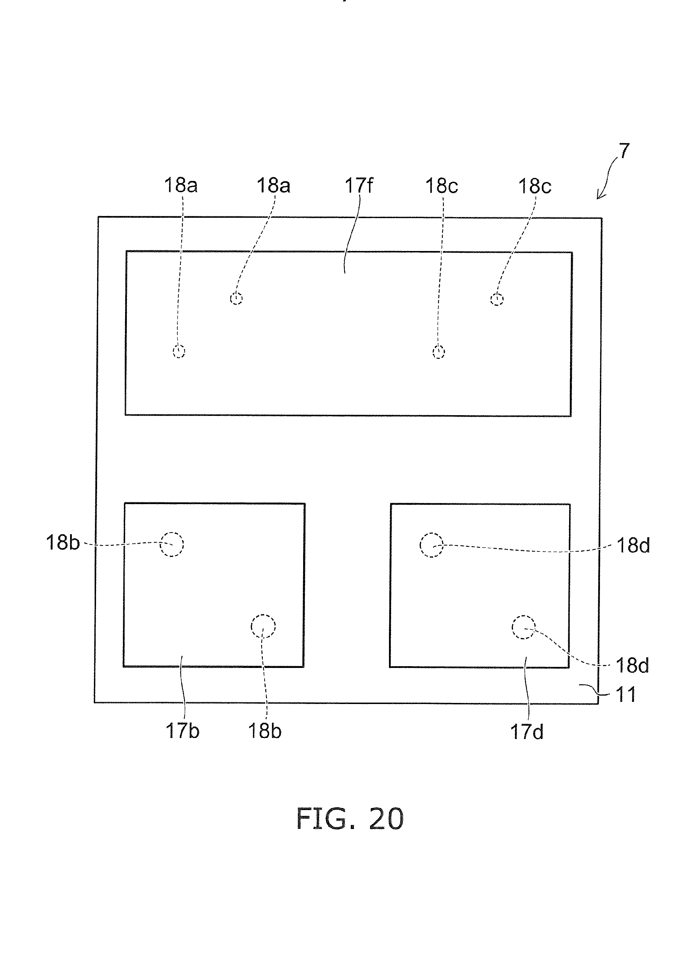

FIG. 20 is a plan view showing the disposition of the pillars of the semiconductor light emitting device according to the embodiment.

As shown in FIG. 20, the semiconductor light emitting device 7 according to the embodiment differs from the semiconductor light emitting device 1 (referring to FIGS. 8A and 8B) according to the first embodiment described above in that one common pillar 17f is provided instead of the pillar 17a which is the positive terminal of the semiconductor layers 21 and the pillar 17c which is the positive terminal of the semiconductor layers 22. The pillar 17f is connected to the interconnect layer 20a by means of the via 18a and is connected to the interconnect layer 20c by means of the via 18c. Thereby, the tint of the emitted light can be adjusted by controlling the potentials of three terminals. Otherwise, the configuration, the manufacturing method, the operations, and the effects of the embodiment are similar to those of the first embodiment described above.

### (Eighth embodiment)

An eighth embodiment will now be described.

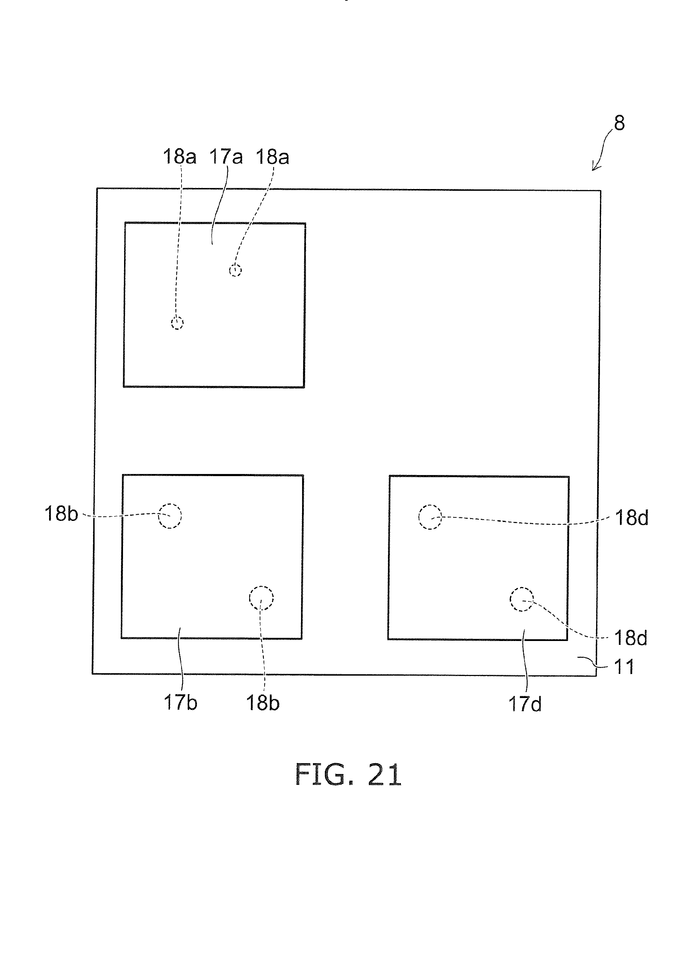

FIG. 21 is a plan view showing the disposition of the pillars of the semiconductor light emitting device according to the embodiment.

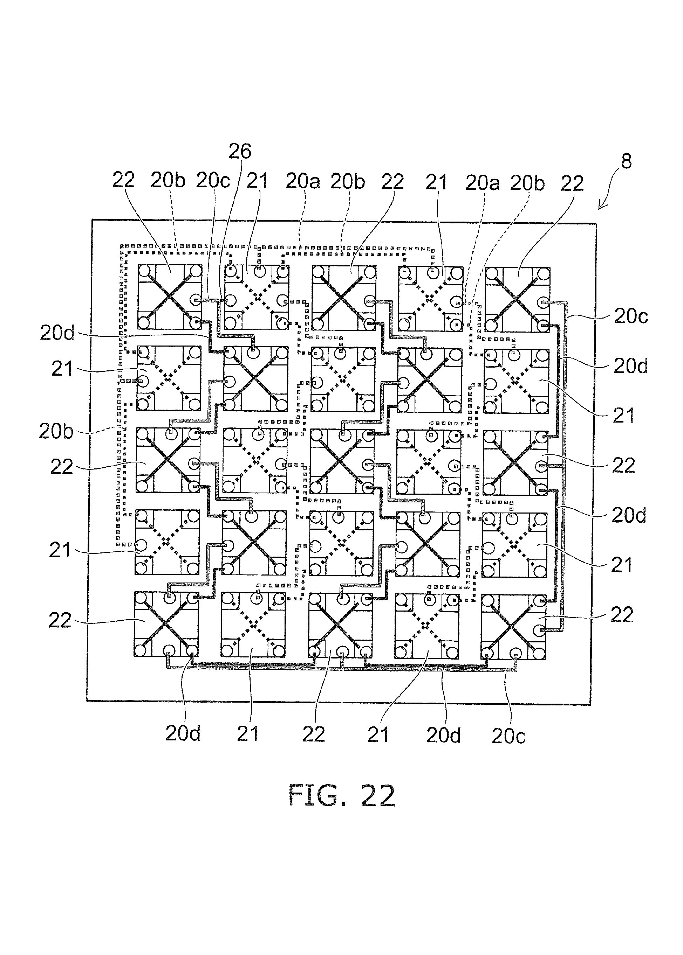

FIG. 22 is a figure showing the connectional relationship between the semiconductor layers and the interconnect layers of the semiconductor light emitting device according to the embodiment.

As shown in FIG. 21, the semiconductor light emitting device 8 according to the embodiment differs from the semiconductor light emitting device 1 (referring to FIG. 2B and FIG. 8A) according to the first embodiment described above in that the pillar 17c and the via 18c are not provided. Also, as shown in FIG. 22, the interconnect layer 20c is connected to the interconnect layer 20a via an interconnect 26. Accordingly, the pillar 17a is connected to both the interconnect layer 20a and the interconnect layer 20c and is connected to both the positive terminal of the semiconductor layers 21 and the positive terminal of the semiconductor layers 22. Thereby, according to the embodiment as well, the tint of the emitted light can be adjusted by controlling the potentials of three terminals. Otherwise, the configuration, the manufacturing method, the operations, and the effects of the embodiment are similar to those of the first embodiment described above.

According to the embodiments described above, a small semiconductor light emitting device for which toning is possible can be realized.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention. Additionally, the embodiments described above can be combined mutually.

## Claims

1. A semiconductor light emitting device (1-8), comprising:
a first semiconductor layer (21) including a first conductivity-type clad layer (21p), an active layer (21a), and a second conductivity-type clad layer (21n) stacked in the first semiconductor layer (21);
a second semiconductor layer (22) including a first conductivity-type clad layer (22p), an active layer (22a), and a second conductivity-type clad layer (22n) stacked in the second semiconductor layer (22);
a continuous insulating layer (13) covering a side surface of the first semiconductor layer (21), a lower surface of the first semiconductor layer (21), a side surface of the second semiconductor layer (22), and a lower surface of the second semiconductor layer (22);
a first fluorescer layer (14, 34) covering an upper surface of the first semiconductor layer (21); and
a second fluorescer layer (15) covering an upper surface of the second semiconductor layer (22).

2. The device (1, 2, 3) according to claim 1, wherein the second fluorescer layer (15) covers the first fluorescer layer (14, 34).

3. The device (1-8) according to claim 1, further comprising:
a third semiconductor layer (21) including a first conductivity-type clad layer (21p), an active layer (21a), and a second conductivity-type clad layer (22n) stacked in the third semiconductor layer (21);
a fourth semiconductor layer (22) including a first conductivity-type clad layer (22p), an active layer (22a), and a second conductivity-type clad layer (22n) stacked in the fourth semiconductor layer (22);
a first interconnect layer (20a) connecting the first conductivity-type clad layer (21p) of the first semiconductor layer (21) to the first conductivity-type clad layer (21p) of the third semiconductor layer (21);
a second interconnect layer (20b) connecting the second conductivity-type clad layer (21n) of the first semiconductor layer (21) to the second conductivity-type clad layer (21n) of the third semiconductor layer (21);
a third interconnect layer (20c) connecting the first conductivity-type clad layer (22p) of the second semiconductor layer (22) to the first conductivity-type clad layer (22p) of the fourth semiconductor layer (22); and
a fourth interconnect layer (20d) connecting the second conductivity-type clad layer (22n) of the second semiconductor layer (22) to the second conductivity-type clad layer (22n) of the fourth semiconductor layer (22),
the continuous insulating layer (13) also covering a side surface of the third semiconductor layer (21), a lower surface of the third semiconductor layer (21), a side surface of the fourth semiconductor layer (22), and a lower surface of the fourth semiconductor layer (22),
the first fluorescer layer (14, 34) also covering an upper surface of the third semiconductor layer (21),
the second fluorescer layer (15) also covering an upper surface of the fourth semiconductor layer (22).

4. The device (1, 2, 3) according to claim 3, wherein the second fluorescer layer (15) covers the first fluorescer layer (14, 34).

5. The device (1-4) according to claim 3, further comprising:
a first pillar (17a) connected to the first interconnect layer (20a);
a second pillar (17b) connected to the second interconnect layer (20b);
a third pillar (17c) connected to the third interconnect layer (20c);
a fourth pillar (17d) connected to the fourth interconnect layer (20d); and
an insulating film (16) covering a side surface and an upper surface of each of the first to fourth pillars (17a, 17b, 17c, 17d).

6. The device (1, 2) according to claim 5, wherein
the second fluorescer layer (15) covers the first fluorescer layer (14, 34), and
an outer surface of the device (1, 2) is formed of the second fluorescer layer (15), the continuous insulating layer (13), the insulating film (16), and the first to fourth pillars (17a-17d).

7. The device (6) according to claim 3, further comprising:
a first pillar (17a) connected to the first interconnect layer (20a);
a second pillar (17b) connected to the second interconnect layer (20b);
a third pillar (17c) connected to the third interconnect layer (20c); and
an insulating film (16) covering a side surface and an upper surface of each of the first to third pillars (17a, 17b, 17c),
the fourth interconnect layer (20d) being connected to the second interconnect layer (20b).

8. The device (8) according to claim 3, further comprising:
a first pillar (17a) connected to the first interconnect layer (20a);
a second pillar (17b) connected to the second interconnect layer (20b);
a third pillar (17d) connected to the fourth interconnect layer (20d); and
an insulating film (16) covering a side surface and an upper surface of each of the first to third pillars (17a, 17b, 17d),
the third interconnect layer (20c) being connected to the first interconnect layer (20a).

9. The device (1) according to claim 1, wherein
the first semiconductor layer (21) and the second semiconductor layer (22) are configured to emit blue light,
the first fluorescer layer (14) is configured to emit red light when the blue light is incident on the first fluorescer layer (14), and
the second fluorescer layer (15) is configured to emit yellow light when the blue light is incident on the second fluorescer layer (15).

10. The device (2) according to claim 1, wherein
the first semiconductor layer (21) and the second semiconductor layer (22) are configured to emit blue light,
the first fluorescer layer (34) is configured to emit orange light when the blue light is incident on the first fluorescer layer (34), and
the second fluorescer layer (15) is configured to emit yellow light when the blue light is incident on the second fluorescer layer (15).

11. The device (3) according to claim 1, further comprising a transparent layer (36) disposed between the first fluorescer layer (14) and the second fluorescer layer (15).

12. A semiconductor light emitting device (1, 2, 3), comprising:
a first semiconductor layer (21) including a p-type clad layer (21p), an active layer (21a), and an n-type clad layer (21n) stacked in the first semiconductor layer (21);
a second semiconductor layer (22) including a p-type clad layer (22p), an active layer (22a), and an n-type clad layer (22n) stacked in the second semiconductor layer (22);
a third semiconductor layer (21) including a p-type clad layer (21p), an active layer (21a), and an n-type clad layer (21n) stacked in the third semiconductor layer (21);
a fourth semiconductor layer (22) including a p-type clad layer (22p), an active layer (22a), and an n-type clad layer (22n) stacked in the fourth semiconductor layer (22);
a continuous insulating layer (13) covering a side surface of the first semiconductor layer (21), a lower surface of the first semiconductor layer (21), a side surface of the second semiconductor layer (22), a lower surface of the second semiconductor layer (22), a side surface of the third semiconductor layer (21), a lower surface of the third semiconductor layer (21), a side surface of the fourth semiconductor layer (22), and a lower surface of the fourth semiconductor layer (22);
a first interconnect layer (20a) connecting the p-type clad layer (21p) of the first semiconductor layer (21) to the p-type clad layer (21p) of the third semiconductor layer (21);
a second interconnect layer (20b) connecting the n-type clad layer (21n) of the first semiconductor layer (21) to the n-type clad layer (22n) of the third semiconductor layer (22);
a third interconnect layer (20c) connecting the p-type clad layer (22p) of the second semiconductor layer (22) to the p-type clad layer (22p) of the fourth semiconductor layer (22);
a fourth interconnect layer (20d) connecting the n-type clad layer (22n) of the second semiconductor layer (22) to the n-type clad layer (22n) of the fourth semiconductor layer (22);
a first pillar (17a) connected to the first interconnect layer (20a);
a second pillar (17b) connected to the second interconnect layer (20b);
a third pillar (17c) connected to the third interconnect layer (20c);
a fourth pillar (17d) connected to the fourth interconnect layer (20d);
an insulating film (16) covering a side surface and an upper surface of each of the first to fourth pillars (17a-17d);
a first fluorescer layer (14, 34) covering an upper surface of the first semiconductor layer (21) and an upper surface of the third semiconductor layer (21); and
a second fluorescer layer (15) covering an upper surface of the second semiconductor layer (22), an upper surface of the fourth semiconductor layer (22), and the first fluorescer layer (14, 34),
an outer surface of the device (1, 2) being formed of the second fluorescer layer (15), the continuous insulating layer (13), the insulating film (16), and the first to fourth pillars (17a-17d).

13. The device (1) according to claim 12, wherein
the first semiconductor layer (21) and the second semiconductor layer (22) are configured to emit blue light,
the first fluorescer layer (14) is configured to emit red light when the blue light is incident on the first fluorescer layer (14), and
the second fluorescer layer (15) is configured to emit yellow light when the blue light is incident on the second fluorescer layer (15).

14. The device (2) according to claim 12, wherein
the first semiconductor layer (21) and the second semiconductor layer (22) are configured to emit blue light,
the first fluorescer layer (34) is configured to emit orange light when the blue light is incident on the first fluorescer layer (34), and
the second fluorescer layer (15) is configured to emit yellow light when the blue light is incident on the second fluorescer layer (15).

15. The device (3) according to claim 12, further comprising a transparent layer (36) disposed between the first fluorescer layer (14) and the second fluorescer layer (15).
